# EUROPEAN PATENT APPLICATION

(11) **EP 4 184 778 A1**
(43) Date of publication of application: **24.05.2023**
(21) Application number: 21846726.4
(22) Date of filing: 19.07.2021
(51) Int. Cl.: H02M 7/42

(54) **HEAT DISSIPATION APPARATUS, INVERTER AND ELECTRONIC DEVICE**

(30) Priority: 24.07.2020 CN 202010725843
(71) Applicant: Huawei Digital Power Technologies Co., Ltd., Shenzhen, Guangdong 518043 (CN)
(72) Inventor: SUN, Faming, Shenzhen, Guangdong 518129 (CN); LI, Quanming, Shenzhen, Guangdong 518129 (CN); CHEN, Jun, Shenzhen, Guangdong 518129 (CN)
(74) Representative: Epping - Hermann - Fischer
(86) International application number: PCT/CN2021/107059
(87) International publication number: WO 2022/017312

(57) **Abstract**

This application discloses a heat dissipation apparatus, an inverter, and an electronic device. The heat dissipation apparatus includes a main heat sink, an extra heat sink, and a heat conducting element, the main heat sink includes a main substrate and a main fin, one end of the main fin is connected to the main substrate, the extra heat sink is located at an end of the main fin farther from the main substrate, the extra heat sink is detachably connected to the main heat sink, and the heat conducting element extends from the main substrate to the extra heat sink, to transfer heat between the main substrate and the extra heat sink. In this application, the heat dissipation apparatus is designed as a split structure. A dual heat dissipation function of the main heat sink and the extra heat sink improves a heat dissipation capability of the heat dissipation apparatus, and improves heat dissipation efficiency. In addition, because the extra heat sink and the inverter provided with the main heat sink are detachably connected, flexible configuration is implemented, and a problem of difficult transportation, installation, and maintenance is avoided.

## Description

This application claims priority to Chinese Patent Application No. 202010725843.3, filed with the China National Intellectual Property Administration on July 24, 2020 and entitled "HEAT DISSIPATION APPARATUS, INVERTER, AND ELECTRONIC DEVICE", which is incorporated herein by reference in its entirety.

### TECHNICAL FIELD

This application relates to the field of heat dissipation technologies, and in particular, to a heat dissipation apparatus, an inverter, and an electronic device.

### BACKGROUND

A photovoltaic inverter is mainly configured to invert direct current power generated by a photovoltaic panel into alternating current power that can access a power grid. The photovoltaic inverter can be applied to a ground (a power station), a rooftop (for commercial use and household use), and a water surface (a fishery-solar hybrid project (system)). When applied to a ground, the photovoltaic inverter is usually installed vertically by using a support. On a rooftop, to avoid shading a surrounding photovoltaic panel from sunlight, the photovoltaic inverter is usually installed obliquely at a small angle. On a water surface in a fishery-solar hybrid project (system), the photovoltaic inverter is usually installed on a floating body floating on water, and is usually installed horizontally to avoid blocking light and stabilize a center of gravity.

Application scenario environments of photovoltaic inverters are complex and harsh, and installation and maintenance are inconvenient. Therefore, natural heat dissipation is usually adopted. A conventional heat sink for natural heat dissipation is located on a back side of a chassis of an inverter. When the inverter is installed horizontally or obliquely at a small angle on a rooftop or in a fishery-solar hybrid project (system) scenario, a heat dissipation capability is severely attenuated (by 20% to 30%). As a result, the inverter is derated (an electric energy yield decreases) in advance under high temperature.

How to improve the heat dissipation capability of the heat sink and reduce difficulty of installation and maintenance should be a research and development direction of the industry.

### SUMMARY

This application provides a heat dissipation apparatus, where thermal energy generated by an inverter is conducted from a main heat sink to an extra heat sink by using a split-type heat dissipation apparatus design. The main heat sink is installed on the inverter. The extra heat sink and the inverter are separately transported. The extra heat sink and the inverter provided with the main heat sink are assembled on site. Disposition of the main heat sink and the extra heat sink improves a heat dissipation capability, and such a split structure realizes flexible configuration and facilitates transportation, installation, and disassembly.

According to a first aspect, this application provides a heat dissipation apparatus. The heat dissipation apparatus includes a main heat sink, an extra heat sink, and a heat conducting element. The main heat sink includes a main substrate and a main fin. One end of the main fin is connected to the main substrate. The extra heat sink is located at an end of the main fin farther away from the main substrate. The extra heat sink is detachably connected to the main heat sink. The heat conducting element extends from the main substrate to the extra heat sink, so as to transfer heat between the main substrate and the extra heat sink.

In this application, the heat dissipation apparatus is designed as a split structure, and the split-type heat dissipation apparatus includes the main heat sink, the extra heat sink, and the heat conducting element. It can be understood that the heat conducting element and the main heat sink may be an integral structure, where the heat conducting element is a part of the main heat sink; or the heat conducting element and the extra heat sink may be an integral structure. The heat dissipation apparatus in this application may be applied to an inverter. The main heat sink is installed on a chassis of the inverter to form an integral whole with the inverter. Then, the extra heat sink and the inverter provided with the main heat sink are separately transported, and are installed on site. Specifically, the extra heat sink is first installed on a ground, a rooftop, a water surface, or the like, and then the inverter provided with the main heat sink is installed on the extra heat sink. Thermal energy generated by a heating element of the inverter is first conducted to the main heat sink. Part of the thermal energy is dissipated through the main heat sink. The other part of the thermal energy is conducted from the main heat sink to the extra heat sink through the heat conducting element, so as to be dissipated. A dual heat dissipation function of the main heat sink and the extra heat sink improves a heat dissipation capability of the heat dissipation apparatus and improves heat dissipation efficiency. In addition, because the extra heat sink and the inverter provided with the main heat sink are detachably connected, flexible configuration is implemented, so that the extra heat sink and the inverter provided with the main heat sink can be separately transported and be assembled on site. An overall weight and size of the inverter are not increased, and a problem of difficult transportation, installation, and maintenance is avoided.

In a possible implementation, a coefficient of thermal conductivity of the heat conducting element is greater than a coefficient of thermal conductivity of the extra heat sink, and the coefficient of thermal conductivity of the heat conducting element is greater than a coefficient of thermal conductivity of the main heat sink. The heat conducting element mainly performs a function of conducting thermal energy between the main substrate and the extra heat sink, and usually needs a comparatively large coefficient of thermal conductivity. A material of the main heat sink and the extra heat sink may be aluminum. The heat conducting element may be made of copper or another material with a large coefficient of thermal conductivity.

In a possible implementation, a contact area between the heat conducting element and the extra heat sink is greater than a contact area between the heat conducting element and the main substrate ("contact" herein may be direct contact or indirect contact, that is, regions between the heat conducting element and the extra heat sink and between the heat conducting element and the main substrate may be filled with another heat conducting material). Specifically, the heat conducting element includes a first thermal conductive interface and a second thermal conductive interface. The first thermal conductive interface is connected to the main substrate of the main heat sink. The second thermal conductive interface is connected to an extra substrate of the extra heat sink. A size of the second thermal conductive interface is greater than a size of the first thermal conductive interface. The heat conducting element is configured to conduct, to the extra heat sink, thermal energy conducted to the main heat sink. As the size of the second thermal conductive interface is set to be greater than the size of the first thermal conductive interface, a contact area between the heat conducting element and the extra substrate is increased, which helps improve heat conduction efficiency and increase rapid diffusion and transfer of thermal energy on the extra substrate.

In a possible implementation, the heat conducting element includes a main body, a first plate body, and a second plate body. The main body is in contact with the main substrate. The first plate body and the second plate body are in contact with the extra heat sink. Both the first plate body and the second plate body bend and extend from an end of the main body farther away from the main substrate, and extension directions thereof are different. In other words, the heat conducting element may have a T-shaped structure, that is, the main body of the heat conducting element may be perpendicular to the first plate body and the second plate body. In another implementation, the main body of the heat conducting element may be alternatively disposed obliquely at a specific angle with the first plate body and the second plate body. The heat conducting element is connected to the main substrate of the main heat sink and the extra substrate of the extra heat sink, to conduct, to the extra heat sink, part of thermal energy conducted to the main heat sink. In this way, the dual heat dissipation function of the main heat sink and the extra heat sink is implemented, so as to improve the heat dissipation capability of the heat dissipation apparatus.

In a possible implementation, the heat conducting element includes a main body and a connecting part. The main body is in contact with the main substrate. The connecting part is in contact with the extra heat sink. One end of the connecting part is connected to an end of the main body farther away from the main substrate. An included angle is formed between the main body and the connecting part. In other words, the main body and the connecting part of the heat conducting element may form an L-shaped structure, that is, the connecting part bends and extends to only one side of the main body.

In a possible implementation, the extra heat sink is provided with a groove, and a surface, of the heat conducting element, in contact with the extra heat sink includes a mating part that is protrusively disposed. The mating part is accommodated in the groove, and a surface of the mating part fits against an inner surface of the groove. The main heat sink and the extra heat sink can be positioned and installed through fitting between the groove and the mating part between the heat conducting element and the extra substrate. In addition, as the groove and the mating part are disposed, the contact area between the heat conducting element and the extra substrate is increased, which helps improve heat conduction efficiency.

In a possible implementation, an elastic element is disposed between the heat conducting element and the extra heat sink. The elastic element is configured to fill a gap between the heat conducting element and the extra heat sink. The elastic element is a graphite foam, a phase-change film, a liquid metal, thermally conductive silicone grease, or a thermally conductive gel. One end of the heat conducting element is connected to the main substrate, and the other end of the heat conducting element is connected to the extra heat sink. Elastic elements may be disposed both between the heat conducting element and the extra heat sink and between the heat conducting element and the main substrate. The elastic elements are configured to fill gaps between the heat conducting element and the extra heat sink and between the heat conducting element and the main substrate, so as to improve heat dissipation efficiency. Specifically, using the heat conducting element and the extra heat sink as an example, when the main heat sink and the extra heat sink are fixedly connected, the heat conducting element and the extra heat sink may be incapable of reaching full contact with each other due to a mechanical tolerance. In addition, when the heat conducting element and the extra heat sink reach contact with each other, even if surface flatness of the heat conducting element and the extra heat sink is good, the heat conducting element and the extra heat sink cannot reach tight contact with each other, but can only reach partial contact with each other, and there are still many extremely tiny gaps or holes between two materials. A heat conductivity of air in the gaps is comparatively poor, which increases thermal resistance and hinders a heat conduction path. Therefore, filling a region between the heat conducting element and the extra heat sink with the elastic element can fill the gaps between the heat conducting element and the extra heat sink, thereby removing air from the gaps, reducing the thermal resistance, and improving thermal energy transfer efficiency. In other words, when the main heat sink and the extra heat sink are fixedly connected, a tight contact connection can be achieved by pressing the elastic element, thereby avoiding a problem that tight contact cannot be achieved due to a mechanical tolerance and surface roughness.

In another implementation, alternatively, connections between the heat conducting element and the extra heat sink and between the heat conducting element and the main substrate may be direct thermal connections.

In a possible implementation, the heat conducting element includes a cavity. A phase-change medium is disposed in the cavity, and the thermal energy is conducted from the main heat sink to the extra heat sink through the phase-change medium. To improve a heat conduction capability of the heat conducting element, the phase-change medium may be disposed in the heat conducting element. The phase-change medium may be water or the like. Specifically, the heat conducting element may be a heat pipe, a vapor chamber, or the like. The heat conducting element further includes a capillary structure. The capillary structure is located on an inner wall of the heat conducting element. The phase-change medium is located in the cavity of the heat conducting element. A region, of the heat conducting element, in contact with the main substrate absorbs heat, so that the phase-change medium in the heat conducting element is gasified under heat, that is, the water changes from liquid to gas. The gas flows in the cavity to another region of the heat conducting element. In a region, of the heat conducting element, in contact with the extra substrate, because temperature is comparatively low, the gas is liquefied into liquid, and releases thermal energy at the same time. The thermal energy is conducted to the extra substrate, and the liquid is attracted to the capillary structure and transmitted to a main substrate side through the capillary structure. In this way, gas-liquid two-phase cycling is formed, thereby implementing rapid conduction of thermal energy, and improving heat conduction efficiency of the heat conducting element.

In a possible implementation, the extra heat sink includes an extra substrate, and a gap is formed between the main fin and the extra substrate. The main fin and the extra substrate are not in contact with each other. In other words, the gap is disposed between the main fin and the extra substrate. In this way, air in a ventilation duct formed by adjacent main fins can be exchanged through the gap between the main fin and the extra substrate. That is, air in the ventilation duct formed by two adjacent main fins is circulating, and hot and cold air can be rapidly exchanged, which helps improve heat dissipation efficiency.

In a possible implementation, there are a plurality of main fins. The plurality of main fins are arranged side by side along a first direction. A thickness of the heat conducting element and a thickness of the main heat sink are dimensions in the first direction. The thickness of the heat conducting element is greater than the thickness of the main fin. A function of the main fin is to dissipate heat. A heat dissipation effect of the main fin is related to an area of the main fin, and is not quite related to the thickness of the main fin in the first direction. Therefore, to reduce a weight of the main heat sink, the main fin is usually comparatively thin. A function of the heat conducting element is to conduct heat. The thickness of the heat conducting element being greater than the thickness of the main fin facilitates heat conduction, thereby improving heat conduction efficiency.

In a possible implementation, a suspension element is disposed on the main substrate, and the suspension element is detachably connected to the extra heat sink. There are a plurality of main fins, and the plurality of main fins are arranged side by side along a first direction. The suspension element and the plurality of main fins are disposed side by side along the first direction. The suspension element may be located at an edge of the main substrate (that is, the main fins are disposed on only one side of the suspension element). Alternatively, the suspension element may be located at a non-edge location on the main substrate, in other words, the suspension element is located between two adjacent main fins (that is, the main fins are disposed on both sides of the suspension element). One end of the suspension element is connected to the main substrate (the suspension element and the main substrate may be an integral structure). The other end of the suspension element is detachably connected to the extra heat sink. Specifically, the end, of the suspension element, connected to the extra heat sink is provided with a clip. During installation, the extra heat sink is first installed on a ground, a rooftop, a water surface, or the like, and then the inverter provided with the main heat sink is pre-positioned and installed on the extra heat sink by using the suspension element (the suspension element may be a mounting ear, and one end of the mounting ear may be provided with a clip structure), thereby implementing preliminary installation of the main heat sink and the extra heat sink.

In another implementation, alternatively, the main heat sink and the extra heat sink may be fixedly connected to each other without using a suspension element. For example, the main substrate is provided with a first mounting hole, and the extra substrate is provided with a second mounting hole. The first mounting hole and the second mounting hole are correspondingly disposed. During installation, a screw sequentially passes through the second mounting hole in the extra substrate and the first mounting hole in the main substrate, so as to implement a detachable connection between the main heat sink and the extra heat sink. In addition, because the main heat sink and the extra heat sink are positioned and installed through the correspondingly disposed first mounting hole and second mounting hole, a problem of skew installation and center-of-gravity instability of the heat dissipation apparatus is avoided.

Similarly, the first mounting hole may be located at an edge of the main substrate, and correspondingly, the second mounting hole is located at an edge of the extra substrate; or the first mounting hole may be located between adjacent main fins, and correspondingly, the second mounting hole is located between adjacent extra fins.

In a possible implementation, the extra heat sink includes an extra substrate, and the extra substrate and the heat conducting element are connected to each other by using a fastener. The fastener may be a detachable structure such as a screw, a bolt, or a clip. After the main heat sink and the extra heat sink are preliminarily positioned and installed by using the suspension element, fastening of the main heat sink and the extra heat sink may not be very stable due to a mechanical tolerance or a fastening structure of the heat sink. To increase overall stability of the heat dissipation apparatus, the heat conducting element and the extra substrate may be fixedly connected by using the fastener, thereby implementing a more stable connection between the main heat sink and the extra heat sink.

In a possible implementation, the heat conducting element and the main substrate of the main heat sink are an integral structure, and the heat conducting element is detachably connected to the extra heat sink. Heat conduction is implemented between the main heat sink and the extra heat sink through the heat conducting element. One end of the heat conducting element is connected to the main substrate, and the other end of the heat conducting element is connected to the extra substrate.

In a possible implementation, a surface, of the extra heat sink, facing the main substrate is provided with a sliding slot; a surface, of the heat conducting element, in contact with the extra substrate is provided with a slider; and the slider is slidably installed in the sliding slot. The main heat sink and the extra heat sink can be detachably connected through slidable mating between the sliding slot on the extra heat sink and the slider on the heat conducting element.

In a possible implementation, the extra heat sink is provided with a fastening hole, a surface, of the heat conducting element, in contact with the extra heat sink is provided with a fastening element, and the fastening element is detachably inserted into the fastening hole. The main heat sink and the extra heat sink can be detachably connected through tight fastening between the fastening hole on the extra heat sink and the fastening element on the heat conducting element.

In a possible implementation, the heat conducting element and the extra heat sink are an integral structure, and the heat conducting element is detachably connected to the main substrate.

In a possible implementation, a first cavity is disposed in the heat conducting element, a second cavity is disposed in the extra heat sink, the first cavity communicates with the second cavity, and a phase-change medium is disposed in both the first cavity and the second cavity. The heat conducting element and the extra heat sink may be an integral structure, and the first cavity communicates with the second cavity, thereby forming an integral heat conducting element provided with the phase-change medium, so as to implement rapid heat conduction.
In a possible implementation, a surface, of the main substrate, facing the extra heat sink is provided with a sliding slot; a surface, of the heat conducting element, in contact with the main substrate is provided with a slider; and the slider is slidably installed in the sliding slot. The main heat sink and the extra heat sink can be detachably connected through slidable mating between the sliding slot on the main substrate and the slider on the heat conducting element.

In a possible implementation, the main substrate is provided with a fastening hole, a surface, of the heat conducting element, in contact with the main substrate is provided with a fastening element, and the fastening element is detachably inserted into the fastening hole. The main heat sink and the extra heat sink can be detachably connected through tight fastening between the fastening hole in the main substrate and the fastening element on the heat conducting element.

In another implementation, the heat conducting element, the main heat sink, and the extra heat sink may all be separate structures, and the heat conducting element may be fastened to the main substrate of the main heat sink and the extra substrate of the extra heat sink in a manner such as insertion or bonding, thereby implementing flexible configuration of the main heat sink and the extra heat sink.

In a possible implementation, the heat dissipation apparatus further includes an auxiliary heat sink, the auxiliary heat sink is connected to the extra heat sink, and the auxiliary heat sink and the extra heat sink together surround the main heat sink partially. Specifically, the main fin includes a first end part, a second end part, and a side part located between the first end part and the second end part. The first end part is connected to the main substrate, and the auxiliary heat sink is located at the side part of the main fin. The auxiliary heat sink is disposed on the extra heat sink, thereby adding a heat dissipation means, so that heat dissipation efficiency can be improved. There may be one auxiliary heat sink, and the auxiliary heat sink is located on one side of the extra heat sink. Alternatively, there may be two auxiliary heat sinks, and the two auxiliary heat sinks are distributed opposite each other on two sides of the extra heat sink.

In a possible implementation, a gap is disposed between the auxiliary heat sink and the main heat sink. Disposing the gap between the auxiliary heat sink and the main heat sink facilitates air circulation, thereby improving heat dissipation efficiency.

In a possible implementation, an auxiliary substrate of the auxiliary heat sink and the extra substrate may be fixedly connected in a manner such as friction stir welding, and a split structure facilitates transportation; or the auxiliary heat sink and the extra heat sink are an integral structure, which simplifies an installation process.

In a possible implementation, an overall size of the extra heat sink may be extended to be the same as a size of the chassis. When the size of the extra heat sink is comparatively large, a heat dissipation area can be increased, thereby effectively improving heat dissipation. When the size of the extra heat sink is set to be comparatively small, the entire heat dissipation apparatus can be thinned.

In a possible implementation, the extra heat sink includes an extra substrate, an extra fin, and a supporting element. A root of the supporting element is connected to the extra substrate. A free end of the supporting element is farther away from the extra substrate. A perpendicular distance between the root of the supporting element and the free end of the supporting element is a height of the supporting element. A root of the extra fin is connected to the extra substrate. A free end of the extra fin is farther away from the extra substrate. A perpendicular distance between the root of the extra fin and the free end of the extra fin is a height of the extra fin. The height of the supporting element is greater than the height of the extra fin. The height of the supporting element and the height of the extra fin are dimensions of the supporting element and the extra fin at corresponding locations, and the height of the supporting element is greater than the height of the extra fin. Therefore, during installation, the supporting element is in contact with a ground or the like, and the extra fin is not in contact with the ground, that is, there is a gap between the extra fin and the ground. This facilitates air circulation, thereby improving heat dissipation efficiency. The supporting element may be located at an edge of the extra substrate (that is, the extra fin is disposed on only one side of the supporting element). Alternatively, the supporting element may be located at a non-edge location on the extra substrate, in other words, the supporting element is located between two adjacent extra fins (that is, the extra fins are disposed on both sides of the supporting element). The supporting element and the extra substrate may be an integral structure, which simplifies an installation process. A quantity of supporting elements is not limited. There may be two supporting elements. To stabilize a center of gravity during installation of the heat dissipation apparatus, the two supporting elements may be symmetrically disposed. In another implementation, alternatively, the quantity of supporting elements may be 3, 4, or the like, to increase installation stability of the heat dissipation apparatus.

In a possible implementation, the free end of the supporting element is inclined relative to a plane on which the extra substrate is located. It can be understood that a range of an inclination angle is greater than or equal to 10° and less than 90°. When the inclination angle is less than 10°, the inclination angle is excessively small, and heat dissipation efficiency cannot be effectively improved. When the inclination angle is greater than or equal to 90°, it is equivalent to a case that the heat dissipation apparatus is vertically installed or reversely installed. When the heat dissipation apparatus is horizontally installed (for example, when an installation carrier is a rooftop or a water surface, the heat dissipation apparatus is usually located on the rooftop or the water surface, and the inverter is located on a side of the heat dissipation apparatus facing away from the rooftop or the water surface, that is, the inverter is located on an upper side of the heat dissipation apparatus), during natural heat dissipation of the heat dissipation apparatus, hot air in the heat dissipation apparatus is blocked by the upper-side inverter in a process of rising, and cannot be effectively dissipated, but can only be dissipated through two side ends of a horizontal ventilation duct. As a result, the heat dissipation capability of the heat dissipation apparatus is severely attenuated (the heat dissipation capability is attenuated by 20% to 30%). If thermal energy generated by the inverter cannot be dissipated in a timely manner, performance of the inverter is affected, leading to reduction of an electric energy yield of the inverter. In this implementation, the free end of the supporting element is disposed obliquely relative to the plane on which the extra substrate is located (it can be understood that a perpendicular projection of the supporting element in a direction perpendicular to the extra substrate may be triangular or trapezoidal), so that there is a specific inclination angle between the extra fin and the rooftop or the water surface. In this way, hot air can be effectively dissipated through the fin, thereby improving exchange efficiency of hot and cold air, and weakening impact on the heat dissipation capability of the heat dissipation apparatus that is caused by the inverter blocking the hot air. This implements effective heat dissipation when the heat dissipation apparatus is horizontally installed.

In a possible implementation, the extra heat sink includes a plurality of extra fins, the plurality of extra fins are disposed side by side on the extra substrate, and a surface, of each extra fin, farther away from the extra substrate is disposed obliquely relative to the extra substrate. In this implementation, surfaces, of all the extra fins, father away from the extra substrate are disposed obliquely relative to the extra substrate (it can be understood that a perpendicular projection of the extra fin in a direction perpendicular to the extra substrate may be triangular or trapezoidal), so that exchange of hot and cold air can be increased, and there is a specific inclination angle between the extra fin and a rooftop or a water surface. In this way, hot air can be effectively dissipated through the inclined fins, thereby improving exchange efficiency of hot and cold air, and weakening impact on the heat dissipation capability of the heat dissipation apparatus that is caused by the inverter blocking the hot air. In addition, because all the extra fins in this implementation are obliquely disposed, a heat dissipation area is increased, thereby implementing effective heat dissipation when the heat dissipation apparatus is horizontally installed.

In a possible implementation, an inclination angle is disposed between the extra substrate and the surface, of each extra fin, farther away from the extra substrate, and the inclination angle is greater than or equal to 10° and less than 90°. When the inclination angle is less than 10°, the inclination angle is excessively small, and heat dissipation efficiency cannot be effectively improved. When the inclination angle is greater than or equal to 90°, it is equivalent to a case that the heat dissipation apparatus is vertically or reversely installed.

According to a second aspect, this application provides an inverter, including a chassis, a heating element, and the heat dissipation apparatus according to any one of the foregoing implementations. The heating element is located in the chassis. The main substrate is fastened to the chassis. A first region is disposed on the main substrate, and the heating element is correspondingly disposed in the first region. At least one heat conducting element is correspondingly disposed on a side of each first region facing away from the heating element.

According to a third aspect, this application provides an electronic device, including a heating element and the heat dissipation apparatus according to any one of the foregoing implementations. The heating element is connected to the heat dissipation apparatus, and thermal energy of the heating element is conducted to the heat dissipation apparatus. The split-type heat dissipation apparatus in this application has a good heat dissipation capability, and the dual heat dissipation function of the main heat sink and the extra heat sink improves heat dissipation efficiency of the heat dissipation apparatus. In addition, because the extra heat sink and the inverter provided with the main heat sink are detachably connected, flexible configuration is implemented, so that the extra heat sink and the inverter provided with the main heat sink can be separately transported and be assembled on site. The overall weight and size of the inverter are not increased, and the problem of difficult transportation, installation, and maintenance is avoided. The heat dissipation apparatus in this application has a simple structure and is convenient to install, and the overall weight and size of the inverter are not increased, which facilitates transportation.

### BRIEF DESCRIPTION OF DRAWINGS

To describe technical solutions in embodiments of this application or in the background more clearly, the following describes the accompanying drawings used in embodiments of this application or in the background.
FIG. 1 is a schematic diagram of an application environment of an inverter according to an implementation of this application;
FIG. 2a is a schematic diagram of installing an inverter on a ground according to an implementation of this application;
FIG. 2b is a schematic diagram of installing an inverter on a rooftop according to an implementation of this application;
FIG. 2c is a schematic diagram of installing an inverter on a water surface according to an implementation of this application;
FIG. 3 is a schematic diagram of an overall structure of a heat dissipation apparatus according to an implementation of this application;
FIG. 4 is a top view of a heat dissipation apparatus according to an implementation of this application;
FIG. 5 is a sectional view of a heat dissipation apparatus according to an implementation of this application;
FIG. 6 is a schematic diagram of a structure of a heat conducting element according to an implementation of this application;
FIG. 7 is a schematic diagram of a structure of a heat conducting element according to another implementation of this application;
FIG. 8 is a schematic diagram of an internal structure of a heat conducting element according to an implementation of this application;
FIG. 9a is a schematic diagram of a structure of detachably connecting a main heat sink and an extra heat sink by using a heat conducting element according to an implementation of this application;
FIG. 9b is a schematic diagram of a structure of detachably connecting a main heat sink and an extra heat sink by using a heat conducting element according to another implementation of this application;
FIG. 9c is a schematic diagram of a structure of detachably connecting a main heat sink and an extra heat sink by using a heat conducting element according to another implementation of this application;
FIG. 9d is a schematic diagram of a structure of detachably connecting a main heat sink and an extra heat sink by using a heat conducting element according to another implementation of this application;
FIG. 9e is a schematic diagram of a structure of a heat conducting element according to an implementation of this application;
FIG. 10 is a schematic diagram of an overall structure of a heat dissipation apparatus according to another implementation of this application;
FIG. 11 is a top view of a heat dissipation apparatus according to another implementation of this application;
FIG. 12 is a sectional view of a heat dissipation apparatus according to another implementation of this application;
FIG. 13 is a schematic diagram of a structure of a heat dissipation apparatus installed on a horizontal plane according to an implementation of this application;
FIG. 14 is a schematic diagram of a structure of a heat dissipation apparatus installed on an inclined plane according to an implementation of this application;
FIG. 15 is a schematic diagram of an overall structure of a heat dissipation apparatus according to another implementation of this application;
FIG. 16 is a top view of a heat dissipation apparatus according to another implementation of this application;
FIG. 17 is a sectional view of a heat dissipation apparatus according to another implementation of this application;
FIG. 18 is a schematic diagram of a structure of a heat dissipation apparatus installed on a horizontal plane according to another implementation of this application;
FIG. 19 is a schematic diagram of a structure of a heat dissipation apparatus installed on an inclined plane according to another implementation of this application;
FIG. 20 is a schematic diagram of an overall structure of a heat dissipation apparatus according to another implementation of this application;
FIG. 21 is a top view of a heat dissipation apparatus according to another implementation of this application;
FIG. 22 is a sectional view of a heat dissipation apparatus according to another implementation of this application;
FIG. 23 is a schematic diagram of a fin shape structure of an extra heat sink according to an implementation of this application; and
FIG. 24 is a schematic diagram of a fin shape structure of an extra heat sink according to an implementation of this application.

### DESCRIPTION OF EMBODIMENTS

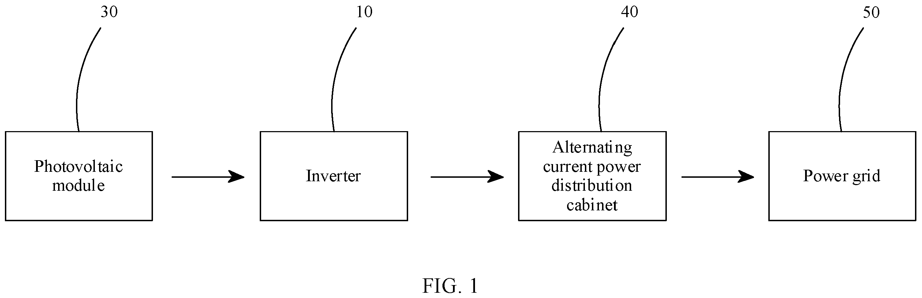

The following clearly describes specific implementations of this application with reference to accompanying drawings. This application provides a heat dissipation apparatus, an inverter, and an electronic device. The inverter is mainly configured to invert direct current power generated by a photovoltaic panel into alternating current power that can access a power grid. The electronic device may be an inverter, or may be another device that needs heat dissipation. FIG. 1 is a schematic diagram of an environment in which an inverter is applied to a photovoltaic power generation system. A photovoltaic module 30 converts solar energy into direct current energy. The inverter 10 converts the direct current energy generated by the photovoltaic module 30 into alternating current energy. The alternating current energy accesses a power grid 50 through a power distribution function of an alternating current power distribution cabinet 40, so as to be used by a user.

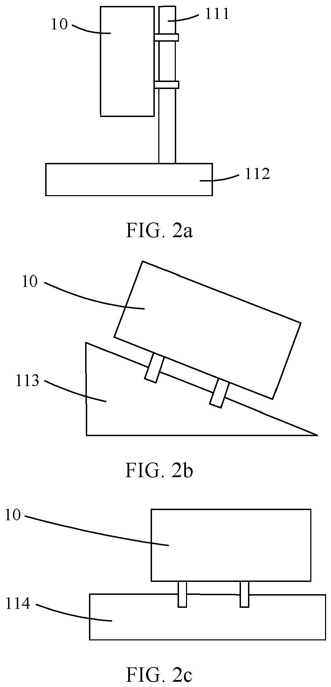

FIG. 2a, FIG. 2b, and FIG. 2c are schematic diagrams of installing an inverter on a ground, a rooftop, and a water surface, respectively. Referring to FIG. 2a, when applied to a ground, the inverter 10 is vertically installed on a ground 112 by using a support 111. A heat dissipation apparatus (not shown in FIG. 2a) is disposed closer to the support 111, that is, the heat dissipation apparatus is located between the inverter 10 and the support 111. Referring to FIG. 2b, when applied to a rooftop, the inverter 10 is usually installed obliquely at a small angle on a rooftop 113, to avoid shading a surrounding photovoltaic panel (not shown in FIG. 2b) from sunlight. A heat dissipation apparatus (not shown in FIG. 2b) is installed closer to the rooftop 113, that is, the heat dissipation apparatus is located between the inverter 10 and the rooftop 113. Referring to FIG. 2c, when applied to a water surface, the inverter 10 is usually installed on a floating body 114 on water in a fishery-solar hybrid project (system), and the inverter 10 is horizontally installed to avoid blocking light and stabilize a center of gravity. A heat dissipation apparatus (not shown in FIG. 2c) is installed closer to the floating body 114 on water, that is, the heat dissipation apparatus is located between the inverter 10 and the floating body 114.

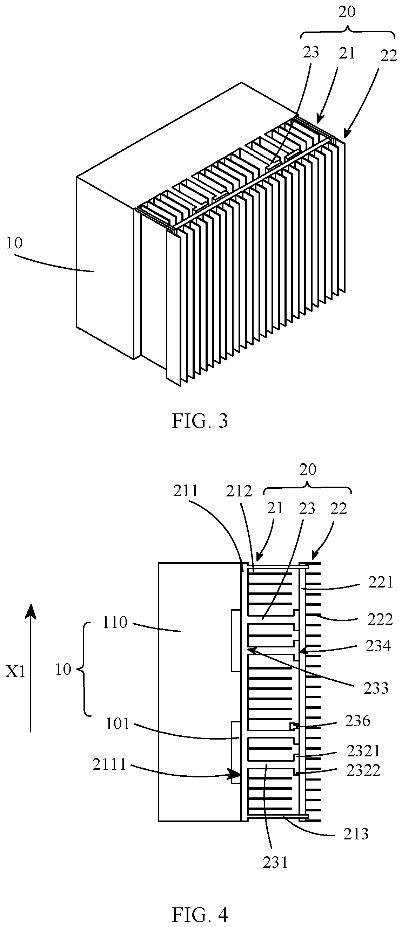

FIG. 3, FIG. 4, and FIG. 5 are respectively a schematic diagram of an overall structure, a top view, and a sectional view of a heat dissipation apparatus. The inverter 10 generates thermal energy in a running process. If heat dissipation cannot be performed on the inverter 10 in a timely manner, an electric energy yield of the inverter 10 is reduced, and even the inverter 10 cannot work normally. Therefore, the heat dissipation apparatus 20 is of great importance to the inverter 10. The heat dissipation apparatus 20 includes a main heat sink 21, an extra heat sink 22, and a heat conducting element 23. The main heat sink 21 includes a main substrate 211 and a main fin 212. The extra heat sink 22 includes an extra substrate 221 and an extra fin 222. One end of the main fin 212 is connected to the main substrate 211. The extra heat sink 22 is located at an end of the main fin 212 farther away from the main substrate 211. The extra heat sink 22 is detachably connected to the main heat sink 21. The heat conducting element 23 extends from the main substrate 211 to the extra heat sink 22, to transfer heat between the main substrate 211 and the extra heat sink 22.

In this application, the heat dissipation apparatus 20 is designed as a split structure, and the split-type heat dissipation apparatus 20 includes the main heat sink 21, the extra heat sink 22, and the heat conducting element 23. It can be understood that the heat conducting element 23 and the main heat sink 21 may be an integral structure, where the heat conducting element 23 is a part of the main heat sink 21; or the heat conducting element 23 and the extra heat sink 22 may be an integral structure. The main heat sink 21 is installed on the inverter 10 to form an integral whole with the inverter 10. Then, the extra heat sink 22 and the inverter 10 provided with the main heat sink 21 are separately transported, and are installed on site. Specifically, the extra heat sink 22 is first installed on a ground, a rooftop, a water surface, or the like, and then the inverter 10 provided with the main heat sink 21 is installed on the extra heat sink 22. Thermal energy generated by the inverter 10 is first conducted to the main heat sink 21. Part of the thermal energy is dissipated through the main heat sink 21. The other part of the thermal energy is conducted from the main heat sink 21 to the extra heat sink 22 through the heat conducting element 23, so as to be dissipated. A dual heat dissipation function of the main heat sink 21 and the extra heat sink 22 improves a heat dissipation capability of the heat dissipation apparatus 20 and improves heat dissipation efficiency. In addition, because the extra heat sink 22 and the inverter 10 provided with the main heat sink 21 can be separately transported and be assembled on site, flexible configuration is implemented, so that an overall weight and size of the inverter 10 are not increased, and a problem of difficult transportation, installation, and maintenance is avoided.

One end of the heat conducting element 23 is connected to the main heat sink 21, and the other end is connected to the extra heat sink 22. A structure of the heat conducting element 23 includes but is not limited to the following two solutions:
In a first solution, referring to FIG. 4, the heat conducting element 23 includes a main body 231, a first plate body 2321, and a second plate body 2322. The main body 231 is in contact with the main substrate 211. The first plate body 2321 and the second plate body 2322 are in contact with the extra substrate 221 of the extra heat sink 22. Both the first plate body 2321 and the second plate body 2322 bend and extend from an end of the main body 231 farther away from the main substrate 211, and extension directions thereof are different. In other words, the heat conducting element 23 may have a T-shaped structure, where the first plate body 2321 and the second plate body 2322 extend in opposite directions. The main body 231 may be perpendicular to the first plate body 2321 and the second plate body 2322, thereby forming the T-shaped structure. In another implementation, the main body 231 of the heat conducting element 23 may be alternatively disposed obliquely at a specific angle with the first plate body 2321 and the second plate body 2322. Specifically, the bodies are disposed based on a structure of the heat dissipation apparatus 20 and a heat dissipation requirement.

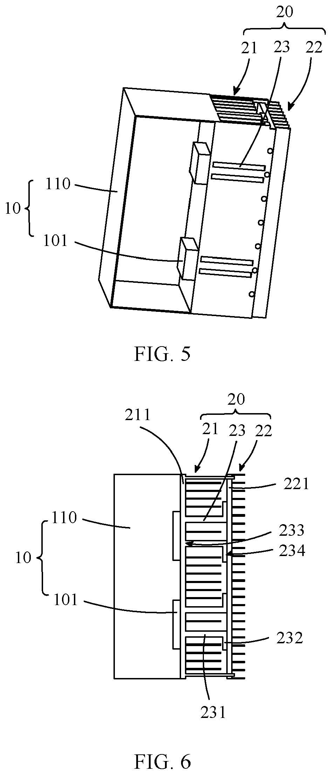

In a second solution, referring to FIG. 6, the heat conducting element 23 includes a main body 231 and a connecting part 232. The main body 231 is in contact with the main substrate 211. The connecting part 232 is in contact with the extra substrate 221. One end of the connecting part 232 is connected to an end of the main body 231 farther away from the main substrate 211. An included angle is formed between the main body 231 and the connecting part 232. In other words, the main body 231 and the connecting part 232 of the heat conducting element 23 may form an L-shaped structure, that is, the connecting part 232 bends and extends to only one side of the main body 231. When a distance between two adjacent heat conducting elements 23 is comparatively small, the heat conducting element 23 of the L-shaped structure may be used, so as to implement rapid transfer of thermal energy.

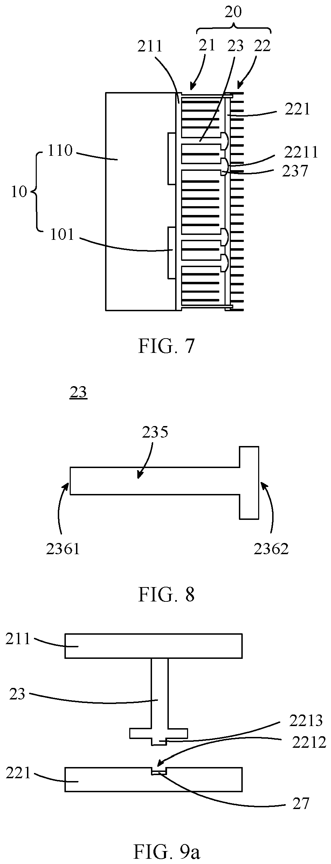

The heat conducting element 23 and the extra substrate 221 may be in contact with each other on a plane (referring to FIG. 4 and FIG. 6). Alternatively, the heat conducting element 23 and the extra substrate 221 may be in contact with each other through a groove. Specifically, referring to FIG. 7, the extra substrate 221 is provided with a groove 2211, and a surface, of the heat conducting element 23, in contact with the extra heat sink 22 includes a mating part 237 that is protrusively disposed. The mating part 237 is accommodated in the groove 2211, and a surface of the mating part 237 fits against an inner surface of the groove 2211. The main heat sink 21 and the extra heat sink 22 can be positioned and installed through mating between the groove 2211 and the mating part 237 between the heat conducting element 23 and the extra substrate 221. In addition, as the groove 2211 and the mating part 237 are disposed, a contact area between the heat conducting element 23 and the extra substrate 221 is increased, which helps improve heat conduction efficiency. The groove 2211 may be an arcuate groove, and the surface, of the mating part 237, fitting against the groove 2211 is an arcuate surface. Such an arcuate structure increases the contact area between the heat conducting element 23 and the extra substrate 221, thereby facilitating rapid heat conduction.

A main function of the heat conducting element 23 is to conduct thermal energy between the main substrate 211 and the extra heat sink 22. Therefore, a coefficient of thermal conductivity of the heat conducting element 23 is greater than a coefficient of thermal conductivity of the extra heat sink 22, and the coefficient of thermal conductivity of the heat conducting element 23 is greater than a coefficient of thermal conductivity of the main heat sink 21, thereby facilitating rapid heat conduction. It can be understood that a material of the main heat sink 21 and the extra heat sink 22 may be aluminum, and the heat conducting element 23 may be made of copper or another material with a large coefficient of thermal conductivity.

In another implementation, alternatively, the heat conducting element 23, the main heat sink 21, and the extra heat sink 22 may be made of a same material, that is, coefficients of thermal conductivity of the heat conducting element 23, the main heat sink 21, and the extra heat sink 22 are the same. For example, the heat conducting element 23, the main heat sink 21, and the extra heat sink 22 may all be made of copper or aluminum.

When the heat conducting element 23, the main heat sink 21, and the extra heat sink 22 are made of a same material (that is, the coefficients of thermal conductivity thereof are the same), to improve a heat conduction effect of the heat conducting element 23, a phase-change medium may also be disposed in the heat conducting element 23, so as to improve a heat conduction capability of the heat conducting element 23. Specifically, referring to FIG. 8, the heat conducting element 23 includes a cavity 235, and a phase-change medium (not shown in FIG. 8, where the phase-change medium may be water or the like) is disposed in the cavity 235. Thermal energy is conducted from a hot end 2361 (that is, an end closer to a heating element) of the heat conducting element 23 to a cold end 2362 (that is, an end farther away from the heating element) of the heat conducting element 23. In other words, the thermal energy is conducted from the main heat sink 21 to the extra heat sink 22 through the phase-change medium. It can be understood that, when the coefficient of thermal conductivity of the heat conducting element 23 is greater than the coefficient of thermal conductivity of the extra heat sink 22, and the coefficient of thermal conductivity of the heat conducting element 23 is greater than the coefficient of thermal conductivity of the main heat sink 21, a phase-change medium may also be disposed in the heat conducting element 23 to improve a heat conduction effect of the heat conducting element 23.

It can be understood that the heat conducting element 23 may be a heat pipe, a vapor chamber, or the like. The heat conducting element 23 further includes a capillary structure. The capillary structure is located on an inner wall of the heat conducting element 23. The phase-change medium is located in the cavity 235 of the heat conducting element 23. A region, of the heat conducting element 23, in contact with the main substrate 211 absorbs heat, so that the phase-change medium in the heat conducting element 23 is gasified under heat, that is, the water changes from liquid to gas. The gas flows in the cavity to another region of the vapor chamber. In a region, of the heat conducting element 23, in contact with the extra substrate 221, because temperature is comparatively low, the gas is liquefied into liquid, and releases thermal energy at the same time. The thermal energy is conducted to the extra substrate 221, and the liquid is attracted to the capillary structure and transmitted to a main substrate 211 side through the capillary structure. In this way, gas-liquid two-phase cycling is formed, thereby implementing rapid conduction of thermal energy, and improving heat conduction efficiency of the heat conducting element.

The contact area between the heat conducting element 23 and the extra substrate 221 is greater than a contact area between the heat conducting element 23 and the main substrate 211 ("contact" herein may be direct contact or indirect contact, that is, regions between the heat conducting element 23 and the extra heat sink 22 and between the heat conducting element 23 and the main substrate 211 may be filled with another heat conducting material). Specifically, referring to FIG. 4 and FIG. 6, the heat conducting element 23 includes a first thermal conductive interface 233 and a second thermal conductive interface 234. The first thermal conductive interface 233 is connected to the main substrate 211. The second thermal conductive interface 234 is connected to the extra substrate 221. A size of the second thermal conductive interface 234 is greater than a size of the first thermal conductive interface 233. The heat conducting element 23 is configured to conduct, to the extra heat sink 22, thermal energy conducted to the main heat sink 21. As the size of the second thermal conductive interface 234 is set to be greater than the size of the first thermal conductive interface 233, the contact area between the heat conducting element 23 and the extra substrate 221 is increased, which helps improve heat conduction efficiency and increase rapid diffusion and transfer of thermal energy on the extra substrate 221.

Referring to FIG. 4, a gap is formed between the main fin 212 and the extra substrate 221. In other words, the main fin 212 and the extra substrate 221 are not in contact with each other. In this way, air in a ventilation duct formed by two adjacent main fins 212 can be exchanged through the gap between the main fin 212 and the extra substrate 221. That is, air in the ventilation duct formed by two adjacent main fins 212 is circulating, and hot and cold air can be rapidly exchanged, which helps improve heat dissipation efficiency.

In a possible implementation, there are a plurality of main fins 212. An arrangement direction of the plurality of main fins 212 is a first direction X1. A thickness of the heat conducting element 23 and a thickness of the main fin 212 are dimensions in the first direction X1. The thickness of the heat conducting element 23 is greater than the thickness of the main fin 212. A function of the main fin 212 is to dissipate heat. A heat dissipation effect of the main fin 212 is related to an area of the main fin 212, and is not quite related to the thickness of the main fin 212 in the first direction. Therefore, to reduce a weight of the main heat sink 21, the main fin 212 is usually comparatively thin. A function of the heat conducting element 23 is to conduct heat. The thickness of the heat conducting element 23 being greater than the thickness of the main fin 212 facilitates rapid conduction of thermal energy, thereby improving heat conduction efficiency.

The main heat sink 21 and the extra heat sink 22 are detachably connected. Referring to FIG. 4, a suspension element 213 is disposed on the main substrate 211 of the main heat sink 21, and the suspension element 213 is detachably connected to the extra substrate 221 of the extra heat sink 22. The suspension element 213 and the plurality of main fins 212 are disposed side by side along the first direction X1. The suspension element 213 may be located at an edge of the main substrate 211 (that is, the main fins 212 are disposed on only one side of the suspension element 213). Alternatively, the suspension element 213 may be located at a non-edge location on the main substrate 211, in other words, the suspension element 213 is located between two adjacent main fins 212 (that is, the main fins 212 are disposed on both sides of the suspension element 213). One end of the suspension element 213 is connected to the main substrate 211 (the suspension element 213 and the main substrate 211 may be an integral structure). The other end of the suspension element 213 is detachably connected to the extra heat sink 22. Specifically, the end, of the suspension element 213, connected to the extra heat sink 22 is provided with a clip. During installation, the extra heat sink 22 is first installed on a ground, a rooftop, a water surface, or the like, and then the inverter 10 provided with the main heat sink 21 is pre-positioned and installed on the extra heat sink 22 by using the suspension element 213 (the suspension element 213 may be a mounting ear, and one end of the mounting ear may be provided with a clip structure), thereby implementing preliminary installation of the main heat sink 21 and the extra heat sink 22. A quantity of suspension elements 213 is not limited, and the quantity of suspension elements 213 may be 2, 3, or the like.

In a possible implementation, referring to FIG. 4, the extra substrate 221 and the heat conducting element 23 are connected to each other by using a fastener 236 (FIG. 4 shows merely an example in which one heat conducting element 23 is provided with the fastener 236; in a specific application environment, each heat conducting element 23 may be provided with a fastener 236, and both the first plate body 2321 and the second plate body 2322 of the heat conducting element 23 may be provided with fasteners 236). The fastener 236 may be a detachable structure such as a screw, a bolt, or a clip. After the main heat sink 21 and the extra heat sink 22 are preliminarily positioned and installed by using the suspension element 213, fastening of the main heat sink 21 and the extra heat sink 22 may not be very stable due to a mechanical tolerance or a fastening structure of the heat sink. To increase overall stability of the heat dissipation apparatus 20, the heat conducting element 23 and the extra substrate 221 may be fixedly connected by using the fastener 236, thereby implementing a more stable connection between the main heat sink 21 and the extra heat sink 22.

In another implementation, alternatively, the main heat sink 21 and the extra heat sink 22 may be fixedly connected to each other without using a suspension element. For example, the main substrate 211 is provided with a first mounting hole, and the extra substrate 221 is provided with a second mounting hole. The first mounting hole and the second mounting hole are correspondingly disposed. During installation, a screw sequentially passes through the second mounting hole in the extra substrate 221 and the first mounting hole in the main substrate 211, so as to implement a detachable connection between the main heat sink 21 and the extra heat sink 22. In addition, because the main heat sink 21 and the extra heat sink 22 are positioned and installed through the correspondingly disposed first mounting hole and second mounting hole, a problem of skew installation and center-of-gravity instability of the heat dissipation apparatus is avoided.

Similarly, the first mounting hole may be located at an edge of the main substrate 211, and correspondingly, the second mounting hole is located at an edge of the extra substrate 221; or the first mounting hole may be located between adjacent main fins 212, and correspondingly, the second mounting hole is located between adjacent extra fins 222. Alternatively, the main heat sink 21 and the extra heat sink 22 may be detachably connected to each other by using the heat conducting element 23. Manners of the detachable connection specifically include but are not limited to the following connection manners:
In a first manner, the heat conducting element 23 and the main substrate 211 of the main heat sink 21 are an integral structure, and the heat conducting element 23 is detachably connected to the extra substrate 221 of the extra heat sink 22.

Specifically, referring to FIG. 9a, a surface, of the extra substrate 221, facing the main substrate 211 is provided with a sliding slot 2212; a surface, of the heat conducting element 23, in contact with the extra substrate 221 is provided with a slider 2213; and the slider 2213 is slidably installed in the sliding slot 2212 and is used for the detachable connection between the main heat sink 21 and the extra heat sink 22. The main heat sink 21 and the extra heat sink 22 can be detachably connected through slidable mating between the sliding slot 2212 on the extra substrate 221 and the slider 2213 on the heat conducting element 23.

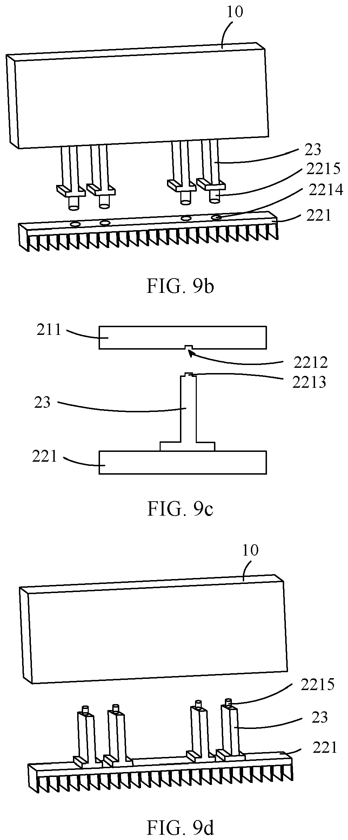

In another implementation, referring to FIG. 9b, the extra substrate 221 is provided with a fastening hole 2214, a surface, of the heat conducting element 23, in contact with the extra substrate 221 is provided with a fastening element 2215, and the fastening element 2215 is detachably inserted into the fastening hole 2214. The main heat sink 21 and the extra heat sink 22 can be detachably connected through tight fastening between the fastening hole 2214 in the extra substrate 221 and the fastening element 2215 on the heat conducting element 23.

In a second manner, the heat conducting element 23 and the extra substrate 221 of the extra heat sink 22 are an integral structure, and the heat conducting element 23 is detachably connected to the main substrate 211 of the main heat sink 21.

Specifically, referring to FIG. 9c, a surface, of the main substrate 211, facing the extra substrate 221 is provided with a sliding slot 2212; a surface, of the heat conducting element 23, in contact with the main substrate 211 is provided with a slider 2213; and the slider 2213 is slidably installed in the sliding slot 2212 and is used for the detachable connection between the main heat sink 21 and the extra heat sink 22. The main heat sink 21 and the extra heat sink 22 can be stably and detachably connected through slidable mating between the sliding slot 2212 on the main substrate 211 and the slider 2213 on the heat conducting element 23.

In another implementation, referring to FIG. 9d, the main substrate 211 is provided with a fastening hole 2214, a surface, of the heat conducting element 23, in contact with the main substrate 211 is provided with a fastening element 2215, and the fastening element 2215 is detachably inserted into the fastening hole 2214. The main heat sink 21 and the extra heat sink 22 can be stably and detachably connected through tight fastening between the fastening hole 2214 in the main substrate 211 and the fastening element 2215 on the heat conducting element 23.

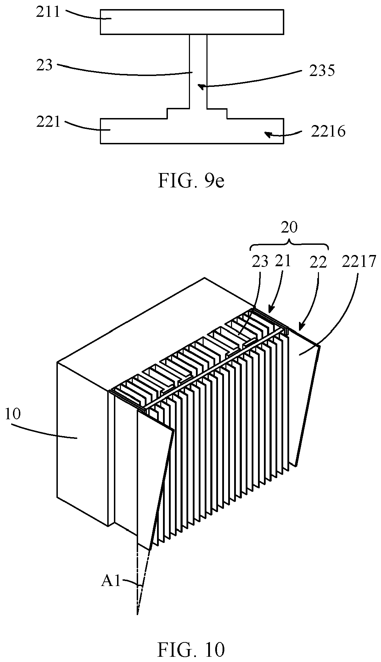

Referring to FIG. 9e, when the heat conducting element 23 and the extra substrate 221 are an integral structure, the heat conducting element 23 is provided with a cavity 235 inside (for differentiation, the cavity 235 is referred to as a first cavity), and the extra substrate 221 is provided with a second cavity 2216 inside. The heat conducting element 23 is butted with the extra substrate 221, so that the first cavity (that is, the cavity 235) communicates with the second cavity 2216. A phase-change medium (not shown in FIG. 9e) is disposed in both the first cavity and the second cavity 2216. The heat conducting element 23 and the extra substrate 221 may be an integral structure, and their cavities communicate with each other, thereby forming an integral heat conducting element provided with the phase-change medium, so as to implement rapid heat conduction.

In another implementation, the heat conducting element 23, the main heat sink 21, and the extra heat sink 22 may all be separate structures, and the heat conducting element 23 may be fastened to the main substrate 211 of the main heat sink 21 and the extra substrate 221 of the extra heat sink 22 in a manner such as insertion or bonding, thereby implementing flexible configuration of the main heat sink 21 and the extra heat sink 22.

Connections between the heat conducting element 23 and the extra substrate 221 and between the heat conducting element 23 and the main substrate 211 may be direct thermal connections. Alternatively, elastic elements 27 may be disposed between the heat conducting element 23 and the extra substrate 221 and between the heat conducting element 23 and the main substrate 211, to improve heat dissipation efficiency. Referring to FIG. 9a, the elastic element 27 may be a graphite foam, a phase-change film, thermally conductive silicone grease, a thermally conductive gel, a liquid metal, or the like. One end of the heat conducting element 23 is connected to the main substrate 211, and the other end of the heat conducting element 23 is connected to the extra heat sink 22. Elastic elements 27 may be disposed both between the heat conducting element 23 and the extra heat sink 22 and between the heat conducting element 23 and the main substrate 211. The elastic elements 27 are configured to fill gaps between the heat conducting element 23 and the extra heat sink 22 and between the heat conducting element 23 and the main substrate 211, so as to improve heat dissipation efficiency. Specifically, using the heat conducting element 23 and the extra heat sink 22 as an example, when the main heat sink 21 and the extra heat sink 22 are fixedly connected, the heat conducting element 23 and the extra heat sink 22 may be incapable of reaching full contact with each other due to a mechanical tolerance. In addition, when the heat conducting element 23 and the extra substrate 221 reach contact with each other, even if surface flatness of the heat conducting element 23 and the extra substrate 221 is good, the heat conducting element and the extra substrate cannot reach fully tight contact with each other, but can only reach partial contact with each other, and there are still many extremely tiny gaps or holes between two materials. A heat conductivity of air in the gaps is comparatively poor, which increases thermal resistance and hinders a heat conduction path. Therefore, filling a region between the heat conducting element 23 and the extra substrate 221 with the elastic element 27 can fill the gaps between the heat conducting element 23 and the extra substrate 221, thereby removing air from the gaps, reducing the thermal resistance, and improving thermal energy transfer efficiency. In other words, when the main heat sink 21 and the extra heat sink 22 are fixedly connected, a tight contact connection can be achieved by pressing the elastic element 27, thereby avoiding a problem that full contact cannot be achieved due to a mechanical tolerance and surface roughness.

In a possible implementation, an overall size of the extra heat sink 22 may be extended to be the same as the size of the inverter 10. When the size of the extra heat sink 22 is comparatively large, a heat dissipation area can be increased, thereby effectively improving heat dissipation. When the size of the extra heat sink 22 is set to be comparatively small, the entire heat dissipation apparatus 20 can be thinned.

Referring to FIG. 4, the inverter 10 includes a chassis 110 and a heating element 101. The heating element 101 is located in the chassis 110. The main heat sink 21 is installed on the chassis 110. The heating element 101 is connected to a side of the main heat sink 21 facing the chassis 110. The extra heat sink 22 is connected to a side of the main heat sink 21 facing away from the chassis 110. The heat conducting element 23 is located between the main heat sink 21 and the extra heat sink 22. The heating element 101 may be fastened to the main substrate 211 of the main heat sink 21 by using a screw, a bolt, a clip, or the like. The heating element 101 may be a device that generates thermal energy, such as a power semiconductor device. It can be understood that the chassis 110 may be a structure whose one side is provided with an opening. When the main heat sink 21 is installed, the main substrate 211 of the main heat sink 21 blocks a location of the opening of the chassis 110, and the heating element 23 is directly fastened to the main substrate 211. In another implementation, alternatively, the chassis 110 may be an intact housing structure, and the main heat sink 21 fits against a surface of the chassis 110.

A first region 2111 is disposed on the main substrate 211, and the heating element 101 is correspondingly disposed in the first region 2111. At least one heat conducting element 23 is correspondingly disposed on a side of each first region 2111 facing away from the heating element 101. The heating element 23 is located in the first region 2111, and thermal energy generated by the heating element 23 is also mainly located in the first region 2111. Therefore, the heat conducting element 23 is also mainly disposed in the first region 2111 correspondingly, so as to help improve heat conduction efficiency, so that the thermal energy generated by the heating element 101 can be concentratedly and rapidly transferred to the extra heat sink 22. Each first region 2111 is connected to at least one heat conducting element 23. To improve heat conduction efficiency, a quantity of heat conducting elements 23 corresponding to each first region 2111 may also be 2, 3, or the like.

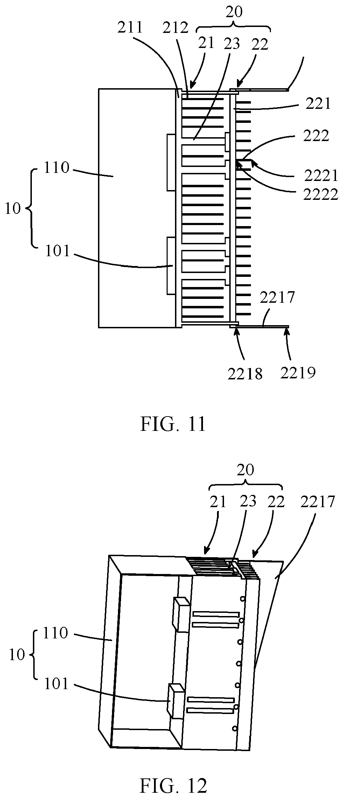

FIG. 10, FIG. 11, and FIG. 12 are respectively a diagram of an overall structure, a top view, and a sectional view of the heat dissipation apparatus according to a possible implementation. A supporting element 2217 is disposed on the extra substrate 221. A root of the supporting element 2217 (to be distinguished from a root of the extra fin, the root of the supporting element 2217 is referred to as a first root 2218) is connected to the extra substrate 221. A free end of the supporting element 2217 (to be distinguished from a free end of the extra fin, the free end of the supporting element 2217 is referred to as a first free end 2219) is farther away from the extra substrate 221. A perpendicular distance between the first root 2218 of the supporting element 2217 and the first free end 2219 of the supporting element 2217 is a height of the supporting element 2217. A root (referred to as a second root 2221) of the extra fin 222 is connected to the extra substrate 221. A free end (referred to as a second free end 2222) of the extra fin 222 is farther away from the extra substrate 221. A perpendicular distance between the second root 2221 of the extra fin 222 and the second free end 2222 of the extra fin 222 is a height of the extra fin 222. The height of the supporting element 2217 is greater than the height of the extra fin 222. The height of the supporting element 2217 and the height of the extra fin 222 are dimensions of the supporting element 2217 and the extra fin 222 at corresponding locations, and the height of the supporting element 2217 is greater than the height of the extra fin 222. Therefore, during installation, the supporting element 2217 is in contact with a ground or the like, and the extra fin 222 is not in contact with the ground, that is, there is a gap between the extra fin 222 and the ground. This facilitates air circulation, thereby improving heat dissipation efficiency.

The free end of the supporting element 2217 is inclined relative to a plane on which the extra substrate 221 is located. It can be understood that a range of an inclination angle is greater than or equal to 10° and less than 90°. When the inclination angle is less than 10°, the inclination angle is excessively small, and heat dissipation efficiency cannot be effectively improved. When the inclination angle is greater than or equal to 90°, it is equivalent to a case that the heat dissipation apparatus is vertically installed or reversely installed.

It can be understood that, when the heat dissipation apparatus 20 is horizontally installed (for example, when an installation carrier is a rooftop or a water surface, the heat dissipation apparatus 20 is usually located on the rooftop or the water surface, and the inverter 10 is located on a side of the heat dissipation apparatus facing away from the rooftop or the water surface), during natural heat dissipation of the heat dissipation apparatus 20, hot air in the heat dissipation apparatus 20 is blocked by the inverter 10 in a process of rising, and cannot be effectively dissipated, but can only be dissipated through two side ends of a ventilation duct. As a result, a heat dissipation capability of the heat dissipation apparatus 20 is severely attenuated (the heat dissipation capability is attenuated by 20% to 30%). If thermal energy generated by the inverter 10 cannot be dissipated in a timely manner, performance of the inverter 10 is affected, leading to reduction of an electric energy yield of the inverter 10. In this implementation, for example, when both the supporting element 2217 and the extra fin 22 are rectangular, that is, the free end (that is, the first free end 2219) of the supporting element 2217 is not disposed obliquely relative to the plane on which the extra substrate 221 is located, but the height of the supporting element 2217 is greater than the height of the extra fin 222, the gap between the extra fin 222 and the ground helps improve heat dissipation efficiency. When the height of the supporting element 2217 is greater than the height of the extra fin 222, and the free end (that is, the first free end 2219) of the supporting element 2217 is disposed obliquely relative to the plane on which the extra substrate 221 is located (it can be understood that a perpendicular projection of the supporting element 2217 in a direction perpendicular to the extra substrate 221 may be triangular or trapezoidal), both the gap between the extra fin 222 and the ground and the oblique disposition of the free end of the supporting element 2217 relative to the extra substrate 221 improve exchange efficiency of hot and cold air and weaken impact on the heat dissipation capability of the heat dissipation apparatus 20 that is caused by the inverter 10 blocking hot and cold air, thereby implementing effective heat dissipation when the heat dissipation apparatus 20 is horizontally installed.

The supporting element 2217 may be located at an edge of the extra substrate 221 (that is, the extra fin 222 is disposed on only one side of the supporting element 2217). Alternatively, the supporting element 2217 may be located at a non-edge location on the extra substrate 221, in other words, the supporting element 2217 is located between two adjacent extra fins 222 (that is, the extra fins 222 are disposed on both sides of the supporting element 2217).

The supporting element 2217 and the extra substrate 221 may be an integral structure, which simplifies an installation process. A quantity of supporting elements 2217 is not limited. There may be two supporting elements 2217. To stabilize a center of gravity during installation of the heat dissipation apparatus 20, the two supporting elements 2217 may be symmetrically disposed. In another implementation, alternatively, the quantity of supporting elements 2217 may be 3, 4, or the like, to increase installation stability of the heat dissipation apparatus 20.

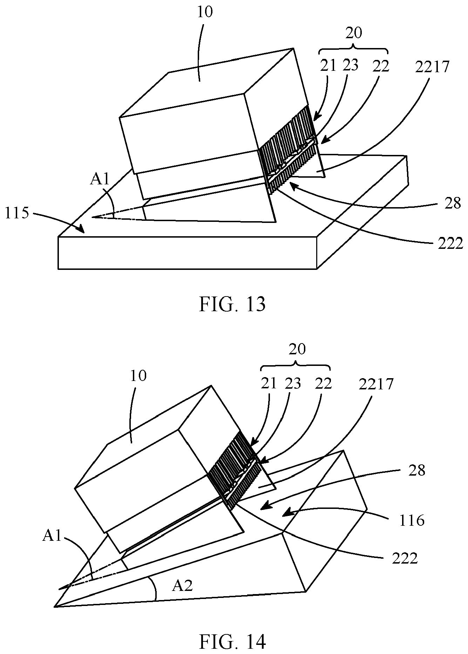

It can be understood that, referring to FIG. 13, in a case of installation on a horizontal plane 115, the supporting element 2217 is in contact with the horizontal plane 115, and a channel 28 (that is, a gap between the extra fins 222 and the horizontal plane 115) is formed between the extra fins 222 and the horizontal plane 115, thereby facilitating air exchange and heat dissipation. Each of the inverter 10, the main heat sink 21, and the extra heat sink 22 is at an inclination angle A1 with the horizontal plane 115. Hot air can be dissipated from two ends of the inclination. Compared with a case in which the extra fins 222 are horizontally disposed, disposing the extra fins 222 obliquely relative to the horizontal plane 115 by using the supporting element 2217 facilitates rise of hot air and improves the heat dissipation capability. Referring to FIG. 14, in a case of installation on an inclined plane 116, the supporting element 2217 is in contact with the inclined plane 116, an included angle between the inclined plane 116 and a horizontal plane is A2, and each of the inverter 10, the main heat sink 21, and the extra heat sink 22 is at an inclination angle of A1+A2 with the horizontal plane. Hot air can be dissipated from two ends of the inclination. This facilitates rise of hot air, improves the heat dissipation capability, and reduces impact caused by the inverter 10 blocking exchange of hot and cold air.

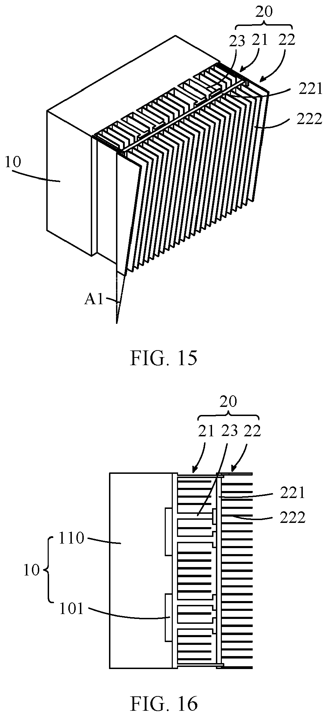

FIG. 15, FIG. 16, and FIG. 17 are respectively a diagram of an overall structure, a top view, and a sectional view of the heat dissipation apparatus according to a possible implementation. The extra heat sink 22 has a plurality of extra fins 222. The plurality of extra fins 222 are disposed side by side on the extra substrate 221. A surface, of each extra fin 222, farther away from the extra substrate 221 is disposed obliquely relative to the extra substrate 221, to improve heat dissipation efficiency. Specifically, in this implementation, surfaces, of all the extra fins 222, father away from the extra substrate 221 are disposed obliquely relative to the extra substrate 221 (it can be understood that a perpendicular projection of the extra fin 222 in a direction perpendicular to the extra substrate 221 may be triangular or trapezoidal), so that exchange of hot and cold air can be increased, and there is a specific inclination angle between the extra fin 222 and a rooftop or a water surface. In this way, hot air can be effectively dissipated through the inclined fins, thereby improving exchange efficiency of hot and cold air, and weakening impact on the heat dissipation capability of the heat dissipation apparatus 20 that is caused by the inverter 10 blocking hot and cold air. In addition, because all the extra fins 222 in this implementation are obliquely disposed, a heat dissipation area is increased, thereby implementing effective heat dissipation when the heat dissipation apparatus 20 is horizontally installed.

An inclination angle A1 is disposed between the extra substrate 222 and the surface, of each extra fin 222, farther away from the extra substrate 221. The inclination angle A1 between the extra substrate 221 and the surface, of the extra fin 222, farther away from the extra substrate 221 is greater than or equal to 10° and less than 90°. When the inclination angle A1 between the extra substrate 221 and the surface, of the extra fin 222, farther away from the extra substrate 221 is less than 10°, the inclination angle is excessively small, and heat dissipation efficiency cannot be effectively improved. When the inclination angle A1 between the extra substrate 222 and the surface, of the extra fin 222, farther away from the extra substrate 221 is greater than or equal to 90°, it is equivalent to a case that the heat dissipation apparatus 20 is vertically or reversely installed.

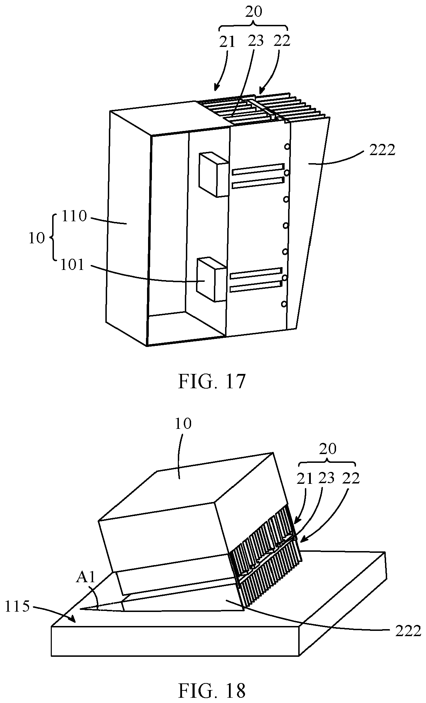

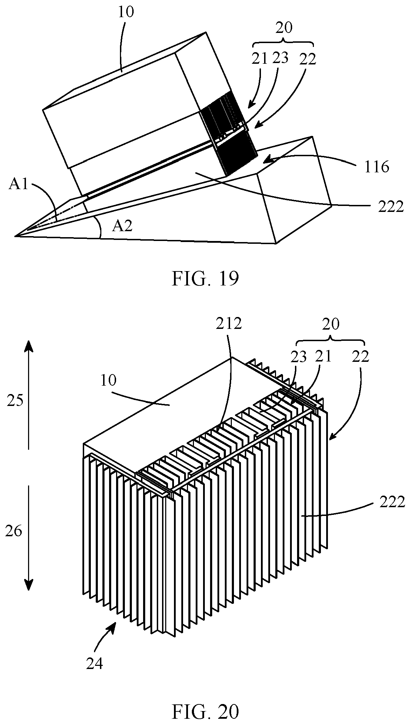

It can be understood that, referring to FIG. 18, in a case of installation on a horizontal plane 115, the extra fins 222 are in contact with the horizontal plane 115, and each of the inverter 10, the main heat sink 21, and the extra heat sink 22 is at an inclination angle A1 with the horizontal plane 115. Hot air can be dissipated from two ends of the inclination. This facilitates rise of hot air. Referring to FIG. 19, in a case of installation on an inclined plane 116, the extra fins 222 are in contact with the inclined plane 116, an included angle between the inclined plane 116 and a horizontal plane is A2, and each of the inverter 10, the main heat sink 21, and the extra heat sink 22 is at an inclination angle of A1+A2 with the horizontal plane. Hot air can be dissipated from two sides. This facilitates rise of hot air and improves the heat dissipation capability.

Compared with the implementation in FIG. 10 where only the supporting element 2217 is disposed obliquely relative to the extra substrate 221, in this implementation, the surface, of each extra fin 222, farther away from the extra substrate 221 is disposed obliquely relative to the extra substrate 221, thereby increasing the heat dissipation area, and implementing effective heat dissipation when the heat dissipation apparatus 20 is horizontally installed. Correspondingly, a weight and costs of the heat dissipation apparatus 20 are also increased. Therefore, whether only the supporting element 2217 is disposed obliquely relative to the extra substrate 221 or the surface, of each extra fin 222, farther away from the extra substrate 221 is disposed obliquely relative to the extra substrate 221 may be set based on a need.

In another implementation, alternatively, a surface, of only some of the extra fins 222, farther away from the extra substrate 221 may be disposed obliquely relative to the extra substrate 221. In other words, during installation, only some of the extra fins 222 are in contact with and fastened to an installation carrier such as the horizontal plane 115 or the inclined plane 116. This may be flexibly performed based on a need.

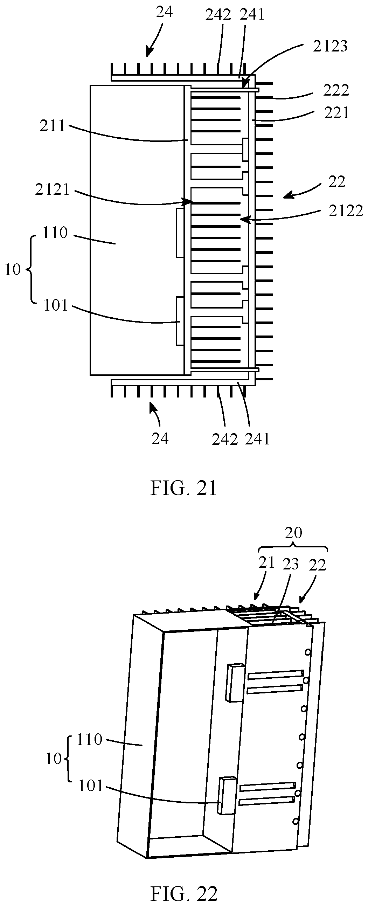

FIG. 20, FIG. 21, and FIG. 22 are respectively a diagram of an overall structure, a top view, and a sectional view of the heat dissipation apparatus according to a possible implementation. The heat dissipation apparatus 20 further includes an auxiliary heat sink 24. The auxiliary heat sink 24 is connected to the extra heat sink 22. The auxiliary heat sink 24 and the extra heat sink 22 together surround the main heat sink 21 partially. The auxiliary heat sink 24 is configured to assist the extra heat sink 22 in heat dissipation. Specifically, the main fin includes a first end part 2121, a second end part 2122, and a side part 2123 located between the first end part 2121 and the second end part 2122. The first end part 2121 is connected to the main substrate 211, and the auxiliary heat sink 24 is located at the side part 2123 of the main fin. The auxiliary heat sink 24 is disposed on the extra heat sink 22, thereby adding a heat dissipation means, so that heat dissipation efficiency can be improved. There may be one auxiliary heat sink 24, and the auxiliary heat sink 24 is located on one side of the extra heat sink 22. Alternatively, there may be two auxiliary heat sinks 24, and the two auxiliary heat sinks 24 are distributed opposite each other on two sides of the extra heat sink 22. In this application, a quantity of auxiliary heat sinks 24 is not limited, and may be set based on a heat dissipation need.

The auxiliary heat sink 24 includes an auxiliary substrate 241 and an auxiliary fin 242. A gap is disposed between the auxiliary substrate 241 and the main heat sink 21, so as to facilitate air circulation, thereby improving heat dissipation efficiency.

It can be understood that the auxiliary substrate 241 may be provided with a cavity. A heat conducting structure such as a heat pipe or a vapor chamber is disposed in the cavity. In this way, part of thermal energy conducted to the extra heat sink 22 is dissipated through the extra fin 222, and the rest of the thermal energy can be conducted to the auxiliary fin 242 through a heat conducting element in the auxiliary substrate 241, so as to be dissipated. This implements multimeans heat dissipation, thereby improving heat dissipation efficiency.

In a possible implementation, the auxiliary substrate 241 and the extra substrate 221 may be fixedly connected in a manner such as friction stir welding, and a split structure facilitates transportation; or the extra heat sink 22 and the auxiliary heat sink 24 are an integral structure, which simplifies an installation process.

When the heat dissipation apparatus is vertically installed in a direction shown in FIG. 20, extension directions of the main fin 212 and the extra fin 222 are parallel to a gravity direction. A ventilation duct is formed between adjacent main fins 212, and a ventilation duct is formed between adjacent extra fins 222. Extension directions of the ventilation ducts are parallel to the gravity direction. During natural heat dissipation, hot air 25 rises, and cold air 26 falls. As the extension directions of the main fin 212 and the extra fin 222 are parallel to the gravity direction (that is, an air circulation direction is parallel to the gravity direction), the hot air 25 is not blocked when passing through the ventilation duct between two fins during rising, and a heat dissipation effect is better.

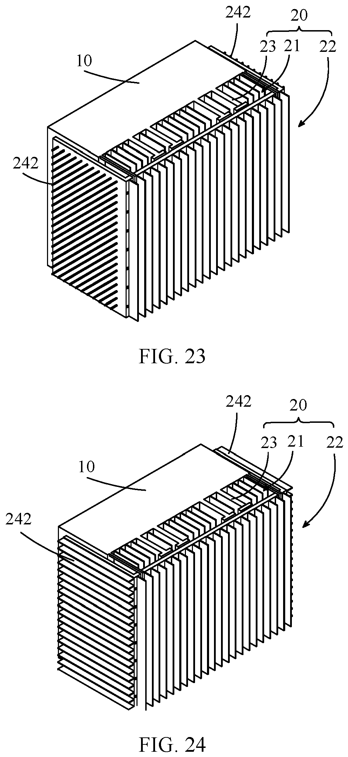

Referring to FIG. 23 and FIG. 24, when the heat dissipation apparatus is vertically installed in a direction shown in FIG. 23 and FIG. 24, the auxiliary fin 242 may be a vertical fin, a horizontal fin, a fin inclined at any angle, a pin fin, or the like. The auxiliary heat sink 24 is on a side face of the inverter 10, so that exchange of hot and cold air is not blocked by the inverter 10. Therefore, a fin shape of the auxiliary heat sink 24 is not limited and may be various shapes, and fin shapes of two auxiliary heat sinks 24 may be different.

It can be understood that, alternatively, the extra heat sink 22 and the auxiliary heat sink 24 may be provided with no extra fin 222 and auxiliary fin 242, and the extra heat sink 22 and the auxiliary heat sink 24 are configured as heat pipes or vapor chambers, to dissipate heat through a phase-change medium in the heat pipes or the vapor chambers. In a possible implementation, the main heat sink 21, the extra heat sink 22, and the auxiliary heat sink 24 may be processed in manners such as die casting, extrusion, relieving, gear shaping, and bonding.

With the split heat dissipation apparatus 20 provided in this application, thermal energy generated by the inverter 10 can be conducted from the main heat sink 21 to the extra heat sink 22 through the heat conducting element 23. The dual heat dissipation function of the main heat sink 21 and the extra heat sink 22 improves the heat dissipation capability of the heat dissipation apparatus 20, and flexible configuration is implemented. In addition, because the extra heat sink 22 and the inverter 10 provided with the main heat sink 21 can be separately transported and be assembled on site, the overall weight and size of the inverter 10 are not increased, and a problem of difficult installation and maintenance is avoided. According to the design of the extra heat sink 22 in this application, when the extra heat sink 22 is installed horizontally or at a small angle on a rooftop and a water surface, an included angle between the heat dissipation apparatus 20 and the horizontal plane is increased, thereby improving the heat dissipation capability of the heat dissipation apparatus 20.

The foregoing is merely some embodiments and implementations of this application, but is not intended to limit the protection scope of this application. Any variation or replacement readily figured out by a person skilled in the art within the technical scope disclosed in this application shall fall within the protection scope of this application.

## Claims

1. A heat dissipation apparatus, wherein the heat dissipation apparatus comprises a main heat sink, an extra heat sink, and a heat conducting element, the main heat sink comprises a main substrate and a main fin, one end of the main fin is connected to the main substrate, the extra heat sink is located at an end of the main fin farther away from the main substrate, the extra heat sink is detachably connected to the main heat sink, and the heat conducting element extends from the main substrate to the extra heat sink, to transfer heat between the main substrate and the extra heat sink.

2. The heat dissipation apparatus according to claim 1, wherein a coefficient of thermal conductivity of the heat conducting element is greater than a coefficient of thermal conductivity of the extra heat sink, and the coefficient of thermal conductivity of the heat conducting element is greater than a coefficient of thermal conductivity of the main heat sink.

3. The heat dissipation apparatus according to claim 2, wherein a contact area between the heat conducting element and the extra heat sink is greater than a contact area between the heat conducting element and the main substrate.

4. The heat dissipation apparatus according to any one of claims 1 to 3, wherein the heat conducting element comprises a main body, a first plate body, and a second plate body, the main body is in contact with the main substrate, the first plate body and the second plate body are in contact with the extra heat sink, both the first plate body and the second plate body bend and extend from an end of the main body farther away from the main substrate, and extension directions thereof are different.

5. The heat dissipation apparatus according to any one of claims 1 to 3, wherein the heat conducting element comprises a main body and a connecting part, the main body is in contact with the main substrate, the connecting part is in contact with the extra heat sink, one end of the connecting part is connected to an end of the main body farther away from the main substrate, and an included angle is formed between the main body and the connecting part.

6. The heat dissipation apparatus according to any one of claims 1 to 3, wherein the extra heat sink is provided with a groove, and a surface, of the heat conducting element, in contact with the extra heat sink comprises a mating part that is protrusively disposed, the mating part is accommodated in the groove, and a surface of the mating part fits against an inner surface of the groove.

7. The heat dissipation apparatus according to claim 1, wherein an elastic element is disposed between the heat conducting element and the extra heat sink, and the elastic element is configured to fill a gap between the heat conducting element and the extra heat sink.

8. The heat dissipation apparatus according to claim 1, wherein the heat conducting element comprises a cavity, a phase-change medium is disposed in the cavity, and the thermal energy is conducted from the main heat sink to the extra heat sink through the phase-change medium.

9. The heat dissipation apparatus according to claim 1, wherein the extra heat sink comprises an extra substrate, and a gap is formed between the main fin and the extra substrate.

10. The heat dissipation apparatus according to claim 1, wherein a suspension element is disposed on the main substrate, and the suspension element is detachably connected to the extra heat sink.

11. The heat dissipation apparatus according to claim 10, wherein the extra heat sink comprises an extra substrate, and the extra substrate and the heat conducting element are connected to each other by using a fastener.

12. The heat dissipation apparatus according to claim 1, wherein the heat conducting element and the main substrate of the main heat sink are an integral structure, and the heat conducting element is detachably connected to the extra heat sink.

13. The heat dissipation apparatus according to claim 12, wherein a surface, of the extra heat sink, facing the main substrate is provided with a sliding slot; a surface, of the heat conducting element, in contact with the extra substrate is provided with a slider; and the slider is slidably installed in the sliding slot.

14. The heat dissipation apparatus according to claim 12, wherein the extra heat sink is provided with a fastening hole, a surface, of the heat conducting element, in contact with the extra heat sink is provided with a fastening element, and the fastening element is detachably inserted into the fastening hole.

15. The heat dissipation apparatus according to claim 1, wherein the heat conducting element and the extra heat sink are an integral structure, and the heat conducting element is detachably connected to the main substrate.

16. The heat dissipation apparatus according to claim 15, wherein a first cavity is disposed in the heat conducting element, a second cavity is disposed in the extra heat sink, the first cavity communicates with the second cavity, and a phase-change medium is disposed in both the first cavity and the second cavity.

17. The heat dissipation apparatus according to claim 1, wherein the heat dissipation apparatus further comprises an auxiliary heat sink, the auxiliary heat sink is connected to the extra heat sink, and the auxiliary heat sink and the extra heat sink together surround the main heat sink partially.

18. The heat dissipation apparatus according to claim 1, wherein the extra heat sink comprises an extra substrate, an extra fin, and a supporting element, a root of the supporting element is connected to the extra substrate, a free end of the supporting element is farther away from the extra substrate, a perpendicular distance between the root of the supporting element and the free end of the supporting element is a height of the supporting element, a root of the extra fin is connected to the extra substrate, a free end of the extra fin is farther away from the extra substrate, a perpendicular distance between the root of the extra fin and the free end of the extra fin is a height of the extra fin, and the height of the supporting element is greater than the height of the extra fin.

19. The heat dissipation apparatus according to claim 18, wherein the free end of the supporting element is inclined relative to a plane on which the extra substrate is located.

20. The heat dissipation apparatus according to claim 1, wherein the extra heat sink comprises a plurality of extra fins, the plurality of extra fins are disposed side by side on the extra substrate, and a surface, of each extra fin, farther away from the extra substrate is disposed obliquely relative to the extra substrate.

21. An inverter, comprising a chassis, a heating element, and the heat dissipation apparatus according to any one of claims 1 to 20, wherein the heating element is located in the chassis, the main substrate is fastened to the chassis, a first region is disposed on the main substrate, and the heating element is correspondingly disposed in the first region, and at least one heat conducting element is correspondingly disposed on a side of each first region facing away from the heat element.

22. An electronic device, comprising a heating element and the heat dissipation apparatus according to any one of claims 1 to 20, wherein the heating element is connected to the heat dissipation apparatus, and thermal energy of the heating element is conducted to the heat dissipation apparatus.
